# EUROPÄISCHE PATENTSCHRIFT

(11) **EP 1 378 150 B1**
(45) Veröffentlichungstag und Bekanntmachung des Hinweises auf die Patenterteilung: **01.09.2004**
(21) Anmeldenummer: 02701086.7
(22) Anmeldetag: 04.03.2002
(51) Int. Cl.: H05K 3/30, H05K 7/12

(54) **HALTEELEMENT FÜR ELEKTRISCHE BAUTEILE ZUR MONTAGE AUF SCHALTUNGSTRÄGERN**
RETAINER ELEMENT FOR ELECTRICAL COMPONENTS FOR ASSEMBLY ON CIRCUIT SUPPORTS
ELEMENT DE RETENUE DESTINE AU MONTAGE DE COMPOSANTS ELECTRIQUES SUR DES SUPPORTS DE CIRCUITS

(30) Priorität: 12.04.2001 AT 6052001
(43) Veröffentlichungstag der Anmeldung: 07.01.2004
(73) Patentinhaber: Siemens AG Österreich, 1210 Wien (AT)
(72) Erfinder: PETRICEK, Martin, A-2020 Hollabrunn (AT)
(74) Vertreter: Matschnig, Franz, Dipl.-Ing.
(86) Internationale Anmeldenummer: PCT/AT2002/000065
(87) Internationale Veröffentlichungsnummer: WO 2002/085084

(56) Entgegenhaltungen:
- EP-A- 0 540 955
- DE-A- 4 231 141
- GB-A- 2 192 492
- US-A- 4 219 172
- US-A- 4 577 259
- US-A- 4 667 270
- US-A- 4 674 008
- US-A- 5 277 612
- "POWER IC RETAINER/HOLDER FOR HEAT TRANSFER ENHANCEMENT" RESEARCH DISCLOSURE, KENNETH MASON PUBLICATIONS, HAMPSHIRE, GB, Nr. 314, 1. Juni 1990 (1990-06-01), Seiten 460-461, XP000132306 ISSN: 0374-4353
- PATENT ABSTRACTS OF JAPAN vol. 2000, no. 01, 31. Januar 2000 (2000-01-31) -& JP 11 274772 A (AIWA CO LTD), 8. Oktober 1999 (1999-10-08)

## Beschreibung

Die Erfindung betrifft ein Halteelement für zumindest ein elektrisches Bauteile zur Montage auf Schaltungsträgern, wie z. B. auf Leiterplatten, das aus zumindest einem Körper besteht, welcher zumindest eine Aufnahme für den Bauteil aufweist, in welche dieser einsetzbar ist, und der Körper zumindest ein als Rasthaken ausgebildetes Befestigungselement aufweist, mittels welchem er an dem Schaltungsträger befestigbar ist.

Bei der Montage von Bauelementen wie beispielsweise Halbleitern auf Leiterplatten ist es notwendig, diese für das Verlöten mit der Leiterplatte in einer bestimmten Position zu halten. Dazu werden üblicherweise eigene Haltevorrichtungen verwendet, mit denen die Bauelemente während des Lötens in ihrer Position gehalten werden. Nach dem Verlöten, welches zumeist maschinell über eine sogenannte Lötwelle erfolgt, muss diese Haltevorrichtung für die Bauelemente wieder entfernt werden.

Nachteilig an dieser üblichen Vorgangsweise ist vor allem der damit verbundene, für das Anbringen und Demontieren der Haltevorrichtung notwendige Zeitaufwand mit den damit einhergehende höheren Montage- und somit Produktionskosten.

Ein Halteelement, das die im ersten Teil des Anspruchs 1 genannten Merkmale aufweist, ist aus US-A-5 277 612 bekannt.

Es ist eine Aufgabe der Erfindung, die Montage von elektrischen Bauelementen auf Schaltungsträgern zeitsparender und kostengünstiger zu gestalten.

Diese Aufgabe wird mit einem im Patentanspruch 1 definierten Halteelement gelöst.

Mit dem erfindungsgemäßen Halteelement wird die Montage von elektrischen Bauteilen auf Schaltungsträgern wesentlich vereinfacht. Die Bauteile wie Halbleiter können einfach in die vorgesehene Aufnahme eingesetzt werden, wo sie vorerst relativ stabil sitzen. Anschließend wird das Halteelement mit seinen Befestigungsmitteln in dem Schaltungsträger fixiert, wobei grundsätzlich die Verbindung auch wieder gelöst werden kann, wenn dies gewünscht ist. Natürlich ist es auch möglich, das Halteelement vorerst an dem Schaltungsträger zu befestigen und es erst anschließend mit den Bauteilen zu bestücken.

Bei einer, erprobten Ausführungsform der Erfindung sind für Befestigungselemente Bohrungen in dem Schaltungsträger vorgesehen, in welchen diese befestigbar sind.

Ein stabiler Sitz des Bauelementes ist dadurch gewährleistet, dass das zumindest eine Befestigungselement als Rasthaken ausgebildet ist.

Vorteilhaft ist es, wenn die Befestigungselemente federnd ausgebildet sind. Auf diese Weise ein besonders stabiler Sitz erreicht werden, es ist aber auch ohne Beschädigung des Schaltungsträgers oder der Rasthaken möglich, diese wieder aus dem Schaltungsträger zu entfernen.

Besonders günstig ist es, wenn die Befestigungselemente vom Körper abstehende, federnde Zungen sind, die eine Rastfläche aufweisen, welche bei verrastetem Zustand mit der vom Körper abgewandten Seite des Schaltungsträgers zusammenwirken.

Außerdem ist es auch noch günstig, wenn die federnden Zungen schräge Auflaufflächen aufweisen, welche an die Rastfläche anschließen. Bei einem Einschieben der Befestigungselemente des Halteelementes in die entsprechenden, zugeordneten Bohrungen in dem Schaltungsträger können die Befestigungselemente dabei leicht in diese Bohrungen entlang der Auflaufflächen hineingleiten, wobei die federnden Befestigungselemente gleichzeitig zurückgedrückt werden, und die Zungen sich an dem Schaltungsträger einhaken können.

Im Sinne einer stabilen Abstützung des Halteelementes ist es weiters, wenn das zumindest eine Befestigungselement an einem Arm angeordnet ist, welcher seitlich, auf einer der zumindest einen Aufnahme abgewandten Seite von dem Körper wegspringend angeordnet ist.

Damit ein stabiler Sitz des Halteelementes gewährleistet ist, sind dabei zumindest zwei Befestigungselemente vorgesehen.

Für einen stabilen Sitz eines Bauteils in einer Aufnahme ist es weiters zweckmäßig, wenn die zumindest eine Aufnahme im wesentlichen an die Form des Gehäuses des Bauteils angepasst ist.

Bei einer vorteilhaften Ausführungsform der Erfindung ist die zumindest eine Aufnahme in einem oberen, dem Schaltungsträger in befestigtem Zustand abgewandten Bereich offen ausgebildet, sodass der Bauteil leicht in die Aufnahme einsetzbar ist.

Damit eine Kontaktierung eines in dem Halteelement angeordneten Bauteils mit dem Schaltungsträger möglich ist, hat die zumindest eine Aufnahme bei einer erprobten Ausführung in einem unteren, dem Schaltungsträger zugewandten Bereich Öffnungen für Anschlusselemente des Bauteils.

Insbesondere Halbleiter werden im Betrieb oftmals sehr warm. Um ein ordnungsgemäßes Funktionieren zu garantieren, ist zumeist eine Entwärmung der Halbleiter notwendig. Dazu werden diese mit einem Kühlkörper, beispielsweise einem Aluprofil, in Kontakt gebracht, sodass die im Halbleiter entstehende Wärme zumindest teilweise auf den Kühlkörper übergehen kann. Damit ein guter Wärmeübergang stattfinden kann, ist es notwendig, dass die Halbleiter einen guten Kontakt mit dem Kühlkörper aufweisen. Üblicherweise werden dazu die Halbleiterbauelemente mit zumindest einem eigenen, zusätzlichen Anpresselement, beispielsweise einer Federblechklammer, an den Kühlkörper angepresst. Nachteilig daran ist wiederum, dass ein zusätzliches Element notwendig ist, dass in einem eigenen Arbeitsschritt angebracht werden muss, sodass längere Montagezeiten mit den entsprechenden, damit verbundenen Kosten auftreten.

Um diese Nachteile zu beheben, ist bei dem erfindungsgemäßen Halteelement die zumindest eine Aufnahme an zumindest einer Seite offen ausgebildet.

Weiters ist es dabei noch vorteilhaft, wenn die zumindest eine Aufnahme eine Bautiefe aufweist, die geringer als die Gehäusedicke des Bauteils ist, sodass dieses mit Bereichen über den Körper des Halteelements übersteht.

Durch diese Ausgestaltung der Aufnahme kann das Bauteil bei einem Anpressen des Halteelementes an den Kühlkörper mit einer Entwärmungsfläche mit dem Kühlkörper kontaktiert werden, sodass eine gute Entwärmung stattfinden kann.

Ein besonders fester Sitz des Bauteils, insbesondere bei einer auf zumindest einer Seite offenen Aufnahme, ist dann gewährleistet, wenn das Halteelement für Anschlusselemente des Bauteils Anschlussaufnahmen hat.

Für eine bessere elektromagnetische Verträglichkeit werden die Anschlusselemente manchmal mit sogenannten Ferritperlen bzw. Ferrithülsen versehen, die zumeist eine Zylinderform haben und auf die Anschlusselemente aufgeschoben werden können. Damit diese einfach positioniert werden können, weisen eine oder mehrere Anschlussaufnahmen im wesentlichen Hohlzylindergestalt auf. Die Ferrithülsen können dann bereits vor Einbringen des Bauteils in die Anschlussaufnahmen eingeschoben werden und sind dort dann sicher positioniert, es ist aber auch möglich, die Hülsen vorab auf die Anschlusselemente aufzuschieben und dann gemeinsam mit dem Bauteil in die Aufnahmen einzubringen.

Falls keine Hülsen wie oben beschrieben auf die Anschlusselemente aufgeschoben werden, ist es für einen stabilen Sitz der Bauteile günstig, wenn eine oder mehrere Anschlussaufnahmen im wesentlichen an den Querschnitt der Anschlusselemente angepasst sind.

Bei einer konkreten Ausführungsform eines Halteelementes weist der Körper in einem unteren Bereich einen oder mehrere Fortsätze auf, in welchem/welchen die Anschlussaufnahme(n) angeordnet ist/sind.

Damit ein Anpressen des/der in dem Halteelement angeordnete(n) Bauteil(e) an einen Kühlkörper zuverlässig und mit hohem Anpressdruck möglich ist, weist der Körper ein oder mehrere Befestigungsöffnungen auf mittels welcher er unter Verwendung von Befestigungsmitteln an einem Kühlkörper befestigbar ist. Auf diese Weise wird beispielsweise ein Verschrauben des Halteelementes mit dem Kühlkörper möglich.

Eine konkrete Ausführungsform der Halteelements zeichnet sich dadurch aus, dass sie aus glasfaserverstärktem Polyamid gebildet ist.

Im folgenden ist die Erfindung an Hand der Zeichnung näher dargestellt. In dieser zeigen die
- Fig. 1: eine perspektivische Rückansicht eines erfindungsgemäßen Halteelements,
- Fig. 2: eine perspektivische Vorderansicht eines Halteelementes nach der Fig. 1,
- Fig. 3: eine Ansicht der Vorderseite,
- Fig. 4: eine Ansicht der Rückseite, und
- Fig. 5: eine Seitenansicht des Halteelementes nach der Fig. 1, sowie
- Fig. 6: eine Draufsicht auf ein in einer Leiteplatte befestigtes erfindungsgemäßes Halteelement.

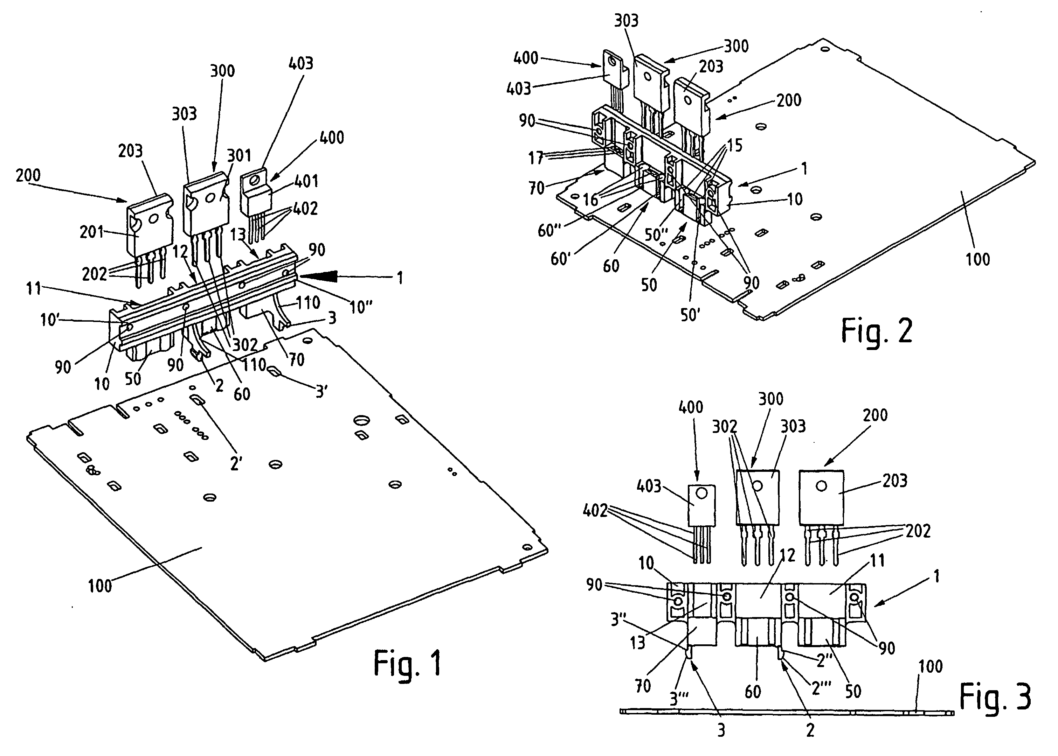

In den Figuren 1 - 6 ist ein erfindungsgemäßes Halteelement 1 für elektrische Bauelemente, beispielsweise für Halbleiter 200, 300, 400 dargestellt. Das Halteelement 1 besteht im wesentlichen aus einem Körper 10, der in der gezeigten Ausführungsform drei Aufnahme 11,12,13 für die Halbleiter 200, 300, 400 aufweist. Grundsätzlich kann ein erfindungsgemäßes Halteelement auch nur eine oder zwei Aufnahmen aufweisen, es können aber auch mehr als drei Aufnahmen, etwa vier, fünf, sechs oder mehr sein.

Die Aufnahmen 11, 12, 13 sind im wesentlichen der Gehäuseform des jeweiligen aufzunehmenden Bauteils angepasst, so dass dieser zuverlässig in der Aufnahme gehalten ist. Beispielsweise ist die Aufnahme 13 für den Halbleiter 400 kleiner als die anderen beiden Aufnahmen 11 und 12 ausgebildet, da auch der Halbleiter 400 eine kleinere Gehäuseform als die beiden anderen Halbleiter 200, 300 aufweist.

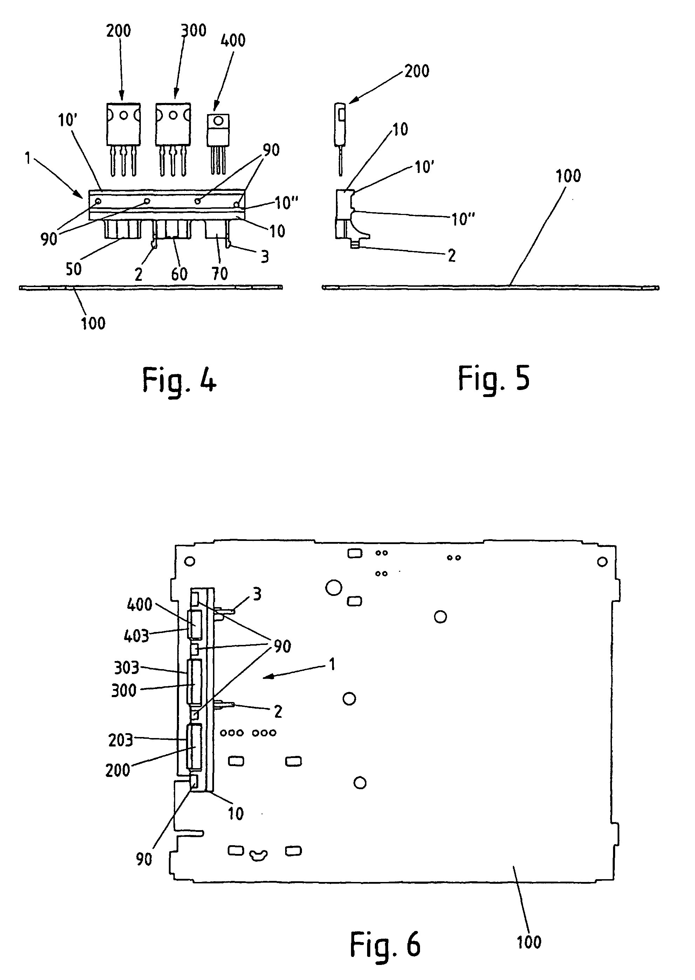

Das in den Figuren gezeigte Halteelement 1 ist insbesondere für Halbleiter vorgesehen, weshalb die Aufnahmen 11 -13 an zumindest an einer Seite des Körpers 10, im folgenden als Vorderseite bezeichnet, offen ausgebildet sind, um eine Entwärmung des Halbleiters 200 - 400 zu ermöglichen. Weiters kann man erkennen, dass die Aufnahmen hinsichtlich ihrer Tiefe geringer bemessen sind als die entsprechende Dicke des Halbleiters, sodass dieser bereichsweise, insbesondere mit jener Fläche 203, 303, 403, über welche eine Entwärmung des Halbleiters 200 - 400 stattfindet, über den Körper 10 übersteht, wie dies insbesondere der Fig. 6 gut zu entnehmen ist.

Für die elektrischen Anschlüsse 202, 302, 402 der Halbleiter weisen die Aufnahmen 11 - 13 in einem unteren Bereich Öffnungen 15, 16, 17 zum Durchstecken der Anschlüsse, die beispielsweise stiftförmig ausgebildet sind, auf. In einem oberen, in an dem Schaltungsträger 100 befestigten Zustand von diesem abgewandten Bereich ist weiters die Aufnahme ebenfalls offen ausgebildet, um ein einfaches Einführen der zu haltenden Bauteile zu ermöglichen, allerdings sind durchaus auch Ausführungsformen ohne eine solche offene Ausbildung der Aufnahme in ihrem oberen Bereich möglich.

Damit bei einer auf einer Seite offenen Aufnahme die elektrischen Bauteile stabil in dem Halteelement 1 angeordnet sind, weist bei der gezeigten Ausführungsform der Erfindung das Halteelement 1 noch eigene Anschlussaufnahmen 50', 50"; 60', 60" auf, in denen einer oder mehrere der Anschlüsse eines Halbleiters aufgenommen sind. Dazu weist der Körper 10 in seinem unteren, dem Schaltungsträger 10 zugewandten Bereich eigene Fortsätze 50, 60, 70 auf, in welchen die Anschlussaufnahmen angeordnet sind, die sich als Fortsetzung der Öffnungen 15, 16, 17 ergeben. Die Anschlussaufnahmen 50', 50"; 60', 60" sind hinsichtlich ihrer Längsausdehnung so ausgebildet, dass die Anschlüsse 202, 302, 402 so weit überstehen, dass ein Verlöten mit einem Schaltungsträger, etwa einer Leiterplatte 100 auf einfache Weise möglich ist und diese Verbindung zuverlässig hält. In der Fig. 3 sind dabei nur jeweils die beiden äußeren Anschlussaufnahmen für die größeren Halbleiter 200, 300 zu erkennen, während von den mittleren Aufnahmen sowie von den Anschlussaufnahmen für den kleineren Halbleiter 400 nur die Öffnungen 15,16,17 zu erkennen sind.

Grundsätzlich können diese Anschlussaufnahmen bereichsweise offen oder auch geschlossen ausgebildet sein; die Einschränkungen liegen hier vorwiegend in einer günstigen Fertigungstechnik. Allerdings ist bei einer bereichsweise offenen Ausführungsform darauf zu achten, dass zumindest ein Anschlusselement zumindest teilweise von der Anschlussaufnahme so umgeben ist, dass der Halbleiter gegen ein seitliches bzw. nach vorne gerichtetes Herausfallen aus seiner Aufnahme 11, 12, 13 gesichert ist. Beispielsweise ist in Fig. 2 gut zu erkennen, dass die beiden Aufnahmen 50', 50", 60', 60" für die beiden äußeren Anschlussstifte der größeren Halbleiter 200, 300 eine im wesentlichen hohlzylinderförnüge Gestalt aufweisen, wobei diese an ihrer Vorderseite offen ausgebildet sind, während die Aufnahme für den mittleren Anschlussstift geschlossen und im wesentlichen an die Querschnittsabmessungen des Stiftes angepasst ist, wodurch der Halbleiter einen stabilen Sitz in dem Halteelement 1 bekommt. Grundsätzlich können die Aufnahmen 50', 50", 60', 60" ohne weiteres die gezeigte Gestalt aufweisen, in der gezeigten Ausführungsform hat diese Ausgestaltung allerdings den Sinn, dass auf den beiden äußeren Anschlussstiften des Halbleiters sogenannte Ferrithülsen für eine bessere elektromagnetische Verträglichkeit aufgeschoben werden, die so komfortabel in den Aufnahmen 50', 50", 60', 60" gehalten sind, ohne dass ein zusätzliches umständliches Halten dieser Hülsen wie ansonsten in der Praxis üblich notwendig ist.

Zur Befestigung des Halteelementes 1 an einer Leiterplatte 100 weist der Körper 10 in einem unteren Bereich Befestigungselemente auf, die bei der gezeigten Ausführung als Rasthaken 2, 3 ausgebildet sind. Mit diesen beiden Rasthaken 2, 3 kann das Halteelement 1 in entsprechend ausgebildete Ausnehmungen 2', 3' in der Leiterplatte eingesetzt und dort verrastet werden. Auf diese Weise wird das Halteelement 1 stabil in der Leiterplatte 100 gehalten und auch die Halbleiter sind stabil positioniert und können in dieser Position mit der Leiterplatte 100 verlötet werden. Das Halteelement selbst verbleibt nach dem Verlöten auf der Leiterplatte 100, sodass kein weiterer Arbeitsschritt für eine Entfernung des Elementes notwendig ist. Außerdem werden durch das Halteelement 1 die elektrischen Bauteile hinsichtlich Ihrer Stabilität in befestigtem Zustand noch unterstützt.

Besonders günstig ist es, wenn, wie in der Zeichnung gezeigt, die Befestigungselemente 2, 3 vom Körper abstehende, federnde Zungen sind, die eine Rastfläche 2", 3" aufweisen, welche bei verrastetem Zustand mit der vom Körper 10 abgewandten Seite des Schaltungsträgers 100 zusammenwirken. Außerdem ist es auch noch günstig, wenn die federnden Zungen 2, 3 schräge Auflaufflächen 2"', 3'" aufweisen, welche an die Rastfläche 2", 3" anschließen. Bei einem Einschieben der Befestigungselemente 2, 3 des Halteelementes 1 in die entsprechenden, zugeordneten Bohrungen 2', 3' in dem Schaltungsträger 100 können die Befestigungselemente dabei leicht in diese Bohrungen entlang der Auflaufflächen 2"', 3"' hineingleiten, wobei die federnden Befestigungselemente gleichzeitig zurückgedrückt werden, und die Zungen sich an dem Schaltungsträger 100 einhaken können.

Bei der gezeigten Ausführungsform des Halteelementes 1 sind die Befestigungselemente 2, 3 jeweils an einem Arm 110 angeordnet, welcher seitlich, auf einer der zumindest einen Aufnahme 11, 12, 13 abgewandten Seite von dem Körper 10 wegspringend angeordnet ist. Besonders günstig ist es dabei, wenn eine mit dem Schaltungsträger 100 im befestigten Zustand des Haltelementes 1 zusammenwirkende Auflagefläche des eines Armes 110 sowie die dem Schaltungsträger 100 zugewandten Flächen der Fortsätze 50, 60, 70 in einer Ebene liegen. Dadurch liegt das Halteelement 1 sowohl mit der Auflagefläche der Arme als auch mit der Unterseite der Fortsätze 50, 60, 70 auf dem Schaltungsträger 100 auf, wodurch eine besonders gute Abstützung des Halteelementes 1 erzielt wird.

Bei größeren Halteelementen kann auch vorgesehen sein, dass mehr als nur zwei Befestigungselemente vorgesehen sind, etwa drei, vier, fünf, sechs, sieben, acht, neun oder zehn Befestigungselemente. Weiters ist aber auch denkbar, etwa nur ein Befestigungselement, beispielsweise in Form eines Rasthakens, für die Befestigung des Halteelementes an der Leiterplatte zu verwenden. Allerdings ist dann in der Regel noch ein entsprechendes Gegenlager notwendig, um das Halteelement entsprechend in Position zu halten.

Wie bereits mehrfach angesprochen, ist in der Regel bei Halbleitern eine Entwärmung notwendig. Dazu werden diese üblicherweise an einen Kühlkörper angepresst, beispielsweise an eine in der Zeichnung nicht dargestellte Aluminiumplatte, die mit dem Schaltungsträger verbunden ist. Dazu wird etwa eine Art Klammer oder ein Bügel verwendet, mit denen jeder Halbleiter gegen den Kühlkörper gepresst werden kann. Nachteilig daran ist, wie eingangs schon erwähnt, dass dabei die Klammer wieder in einem eigenen Arbeitsschritt bei jedem Halbleiter angebracht werden muss.

Um diese Problematik zu vereinfachen, weist der Körper 10 des erfindungsgemäßen Halteelementes 1 eine oder mehrere Öffnungen 90 auf, über welche der Körper 10 mit dem Kühlkörper verschraubt werden kann, wobei das Halteelement so angeordnet ist, dass der Körper 10 mit der geöffneten Seite der Aufnahme(n) zu dem Kühlkörper hinweist. Durch das Verschrauben des Körpers 10 mit dem Kühlkörper können die Halbleiter 200, 300, 400 mit ihrer Entwärmungsfläche 203, 303, 403 mit hohem Anpressdruck gegen den Kühlkörper gepresst werden, sodass ein guter Wärmeübergang stattfinden kann.

Das Halteelement 1 besteht üblicherweise aus einem hochtemperaturbeständigen Kunststoff, beispielsweise aus glasfaserverstärktem Polyamid. Damit bei den hohen Anpressdrücken bei einem Verschrauben des Körpers 10 mit einem Kühlkörper der Körper 10 eine nicht zu starke Durchbiegung erfährt, ist er bei der gezeigten Ausführungsform der Erfindung in einem hinteren, der die Aufnahmen aufweisenden Seite abgewandten Bereich verstärkt ausgebildet. Beispielsweise verlaufen in diesem Bereich über die gesamte Breite des Körpers 10 in einem oberen und einem unteren Bereich Verstärkungen, etwa in Form von Balken 10', 10". Diese sind bei der gezeigten Ausführungsform durchgehend ausgebildet, können aber auch nur bereichsweise an den besonders belasteten Stellen angeordnet sein. Die Verstärkungen können einstückig mit dem Körper 10 ausgebildet oder zusätzlich auf diesem angeordnet sein. Gemäß der gezeigten Ausführungsform hat es sich als günstig erwiesen, wenn in einer Seitenansicht wie nach Fig. 5 der Körper an seiner Rückseite gemeinsam mit den Balken 10', 10" im wesentlichen ein U-Profil hat. Natürlich ist aber auch die Verstärkung des Körpers beispielsweise mit nur einem solchen Balken denkbar.

## Patentansprüche

1. Halteelement für zumindest ein im Betrieb zu entwärmendes elektrisches Bauteil zur Montage auf Schaltungsträgern, wie z.B. auf Leiterplatten, wobei das Halteelement aus zumindest einem Körper (10) besteht, welcher zumindest eine Aufnahme (11,12,13) für den Bauteil (200, 300, 400) aufweist, in welche dieser einsetzbar ist, und der Körper (10) zumindest ein als Rasthaken ausgebildetes Befestigungselement (2, 3) aufweist mittels welchem er an dem Schaltungsträger (100) befestigbar ist, **dadurch gekennzeichnet, dass** die zumindest eine Aufnahme (11, 12, 13) im Wesentlichen an die Form des Gehäuses (201, 301, 401) des Bauteils (200, 300, 400) angepasst und an zumindest einer Seite offen ausgebildet ist und eine Bautiefe aufweist, die geringer als die Gehäusedicke des Bauteils (200, 300, 400) ist, sodass dieses mit Bereichen (203, 303, 403) über den Körper (10) übersteht, und der Körper (10) ein oder mehrere Befestigungsöffnungen (90) aufweist, mittels welcher er unter Verwendung von Befestigungsmitteln an einem Kühlkörper befestigbar ist.

2. Halteelement nach Anspruch 1, **dadurch gekennzeichnet, dass** für Befestigungselemente (2, 3) Bohrungen (2', 3') in dem Schaltungsträger (100) vorgesehen sind, in welchen diese befestigbar sind.

3. Halteelement nach Anspruch 1 oder 2, **dadurch gekennzeichnet, dass** die Befestigungselemente (2, 3) federnd ausgebildet sind.

4. Halteelement nach einem der Ansprüche 1 bis 3, **dadurch gekennzeichnet, dass** die Befestigungselemente (2, 3) vom Körper (10) abstehende, federnde Zungen sind, die eine Rastfläche (2", 3") aufweisen, welche bei verrastetem Zustand mit der vom Körper (10) abgewandten Seite des Schaltungsträgers (100) zusammenwirken.

5. Halteelement nach Anspruch 4; **dadurch gekennzeichnet, dass** die federnden Zungen (2, 3) schräge Auflaufflächen (2"'; 3"') aufweisen, welche an die Rastfläche (3") anschließen.

6. Halteelement nach einem der Ansprüche 1 bis 5, **dadurch gekennzeichnet, dass** das zumindest eine Befestigungselement (2, 3) an einem Arm (110) angeordnet ist, welcher seitlich, auf einer der zumindest einen Aufnahme (11,12,13) abgewandten Seite von dem Körper (10) wegspringend angeordnet ist

7. Halteelement nach einem der Ansprüche 1 bis 6, **gekennzeichnet durch** zumindest zwei Befestigungselemente (2,3).

8. Halteelement nach einem der Ansprüche 1 bis 7, **dadurch gekennzeichnet, dass** die zumindest eine Aufnahme (11, 12, 13) in einem oberen, dem Schaltungsträger (100) in befestigtem Zustand abgewandten Bereich offen ausgebildet ist, sodass der Bauteil (200, 300, 400) in die Aufnahme (11,12,13) einführbar ist.

9. Halteelement nach einem der Ansprüche 1 bis 8, **dadurch gekennzeichnet dass** die zumindest eine Aufnahme (11, 12, 13) in einem unteren, dem Schaltungsträger (100) zugewandten Bereich Öffnungen für Anschlusselemente (202, 302, 402) des Bauteils (200, 300, 400) hat.

10. Halteelement nach einem der Ansprüche 1 bis 9, **dadurch gekennzeichnet, dass** es für Anschlusselemente (202,302,402) des Bauteils (200,300,400) Anschlussaufnahmen (50', 50"; 60',60") hat.

11. Halteelement nach Anspruch 10, **dadurch gekennzeichnet, dass** eine oder mehrere Anschlussaufnahmen (50', 50"'; 60', 60"') im wesentlichen Hohlzylindergestalt aufweisen.

12. Halteelement nach Anspruch 10 oder 11, **dadurch gekennzeichnet, dass** eine oder mehrere Anschlussaufnahmen (50"; 60") im wesentlichen an den Querschnitt der Anschlusselemente (202, 302, 402) angepasst sind.

13. Halteelement nach einem der Ansprüche 10 bis 12, **dadurch gekennzeichnet, dass** der Körper (10) in einem unteren Bereich einen oder mehrere Fortsätze (50, 60, 70) aufweist, in welchem/welchen die Anschlussaufnahme(n) (50', 50"; 60', 60") angeordnet ist/sind.

14. Halteelement nach einem der Ansprüche 1 bis 13, **dadurch gekennzeichnet, dass** es aus glasfaserverstärktem Polyamid gebildet sind.

15. Halteelement nach einem der Ansprüche 1 bis 14 zur Montage von einem oder mehreren Halbleitern auf einem Schaltungsträger.

## Claims

1. A retaining element for at least one electrical component to be cooled during operation thereof when mounted on a circuit board, such as a printed board, which retaining element consists of at least one body (10) having at least one recess (11, 12, 13) for accommodation of said component (200, 300, 400) which is adapted to be inserted into said recess, which body (10) has at least one catch-type securing element (2, 3), by means of which it can be attached to said circuit board (100), **characterized in that** said at least one recess (11, 12, 13) conforms substantially to the shape of the housing (201, 301, 401) of said component (200; 300, 400) and is open on at least one side thereof and has a depth which is less than the thickness of the housing of said component (200, 300, 400) so that the latter protrudes from said body (10) in regions (203, 303, 403) and that said body (10) has one or more mounting holes (90), by means of which it can be attached to a heat sink by the use of fastening means.

2. A retaining element as defined in claim 1, **characterized in that** bores (2', 3') are provided in said circuit board (100) for said securing elements (2, 3) such that the latter can be mounted therein.

3. A retaining element as defined in claim 1 or claim 2, **characterized in that** said securing elements (2, 3) are of a resilient nature.

4. A retaining element as defined in any one of claims 1 to 3, **characterized in that** said securing elements (2, 3) are resilient tongues projecting away from said body (10), which tongues have a locking surface (2", 3") which cooperates, in the locked state, with that surface of said circuit board (100) which is remote from said body (10).

5. A retaining element as defined in claim 4, **characterized in that** said resilient tongues (2, 3) have an inclined slide-in surface (2"', 3"') adjoining said locking surface (3").

6. A retaining element as defined in any one of claims 1 to 5, **characterized in that** said at least one securing element (2, 3) is disposed on an arm (110) which is disposed on that side of said body (10) which is remote from said at least one recess (11, 12, 13) and projects laterally away from said body.

7. A retaining element as defined in any one of claims 1 to 6, **characterized by** at least two securing elements (2, 3).

8. A retaining element as defined in any one of claims 1 to 7, **characterized in that,** considered when said retaining element is locked in position, said at least one recess (11, 12, 13) is open in an upper region remote from said circuit board (100) such that said component (200, 300, 400) can be inserted into said recess (11, 12, 13).

9. A retaining element as defined in any one of claims 1 to 8, **characterized in that** said at least one recess (11, 12, 13) has, in a lower region facing said circuit board (100), openings for connecting means (202, 302, 402) for said component (200, 300, 400).

10. A retaining element as defined in any one of claims 1 to 9, **characterized in that** it has connecting sockets (50', 50"; 60', 60") for said connecting means (202, 302, 402) for said component (200, 300, 400).

11. A retaining element as defined in claim 10, **characterized in that** one or more of said connecting sockets (50', 50"', 60', 60"') have a substantially hollow cyclindrical shape.

12. A retaining element as defined in claim 10 or claim 11, **characterized in that** one or more of said connecting sockets (50"; 60") are substantially adapted to conform to the cross-section of said connecting means (202, 302, 402).

13. A retaining element as defined in any one of claims 10 to 12, **characterized in that** said body (10) has, in a lower region, one or more extensions (50, 60, 70), in which said socket(s) (50', 50"; 60', 60") is/are disposed.

14. A retaining element as defined in any one of claims 1 to 13, **characterized in that** it is made of fiberglass-reinforced polyamide.

15. A retaining element as defined in any one of claims 1 to 14 for use in mounting one or more semi-conductors on a circuit board.

## Revendications

1. Elément de retenue pour au moins un composant électrique à refroidir pendant le fonctionnement pour le montage sur des supports de circuits, comme par exemple sur des cartes de circuits imprimés, l'élément de retenue comportant au moins un corps (10) comprenant au moins un réceptacle (11, 12, 13) pour le composant (200, 300, 400) dans lequel il peut être introduit et le corps (10) comprenant au moins un élément de fixation (2, 3) configuré comme un crochet d'enclenchement à l'aide duquel il peut être fixé sur le support de circuits (100), **caractérisé en ce que** ledit au moins un réceptacle (11, 12, 13) est adapté sensiblement à la forme du boîtier (201, 301, 401) du composant (200, 300, 400) et est ouvert sur au moins un côté en ayant une profondeur qui est inférieure à l'épaisseur du boîtier du composant (200, 300, 400), de sorte que celui-ci dépasse par zones (203, 303, 403) du corps (10), et **en ce que** le corps (10) comprend une ou plusieurs ouverture(s) de fixation (90), à l'aide de laquelle (desquelles) il peut être fixé sur un élément de refroidissement en utilisant des moyens de fixation.

2. Elément de retenue selon la revendication 1, **caractérisé en ce que** dans le support de circuits (100) sont prévues des orifices (2', 3') pour des éléments de fixation (2, 3) dans lesquels ceux-ci peuvent être fixés.

3. Elément de retenue selon la revendication 1 ou 2, **caractérisé en ce que** les éléments de fixation (2, 3) sont configurés comme des éléments souples.

4. Elément de retenue selon l'une quelconque des revendications 1 à 3, **caractérisé en ce que** les éléments de fixation (2, 3) sont des languettes souples dépassant du corps (10) et comprenant une surface d'enclenchement (2", 3") qui, en position d'enclenchement, est en interaction avec le côté du support de circuits (100) opposé au corps (10).

5. Elément de retenue selon la revendication 4, **caractérisé en ce que** les languettes souples (2. 3) sont munies de surfaces d'appui inclinées (2"', 3''') qui sont disposées dans le prolongement de la surface d'enclenchement (3").

6. Elément de retenue selon l'une quelconque des revendications 1 à 5, **caractérisé en ce que** ledit au moins un élément de fixation (2, 3) est disposé sur un bras (110) qui est disposé latéralement sur un côté opposé audit au moins un réceptacle (11, 12, 13) en s'écartant du corps (10).

7. Elément de retenue selon l'une quelconque des revendications 1 à 6, **caractérisé par** au moins deux éléments de fixation (2, 3).

8. Elément de retenue selon l'une quelconque des revendications 1 à 7, **caractérisé en ce que** ledit au moins un réceptacle (11, 12, 13) est ouvert dans une zone supérieure qui, en position de fixation, est opposée au support de circuits (100), de sorte que le composant (200, 300, 400) peut être introduit dans le réceptacle (11, 12, 13).

9. Elément de retenue selon l'une quelconque des revendications 1 à 8, **caractérisé en ce que** ledit au moins un réceptacle (11, 12, 13) comprend, dans une zone inférieure dirigée vers le support de circuits (100), des ouvertures pour des éléments de raccordement (202, 302, 402) du composant (200, 300, 400).

10. Elément de retenue selon l'une quelconque des revendications 1 à 9, **caractérisé en ce qu'**il comprend des réceptacles de raccordement (50', 50", 60', 60") pour des éléments de raccordement (202, 302, 402) du composant (200, 300, 400).

11. Elément de retenue selon la revendication 10, **caractérisé en ce qu'**un ou plusieurs réceptacle (s) de raccordement (50', 50''', 60', 60''') ont sensiblement une configuration cylindrique creuse.

12. Elément de retenue selon la revendication 10 ou 11, **caractérisé en ce qu'**un ou plusieurs réceptacle(s) de raccordement (50", 60") est (sont) sensiblement adapté(s) à la section des éléments de raccordement (202, 302, 402).

13. Elément de retenue selon l'une quelconque des revendications 10 à 12, **caractérisé en ce que** le corps (10) comprend dans une zone inférieure un ou plusieurs prolongement(s) (50, 60, 70) dans lequel (lesquels) est(sont) disposé(s) le(les) réceptacle(s) de raccordement (50', 50", 60', 60'') .

14. Elément de retenue selon l'une quelconque des revendications 1 à 13, **caractérisé en ce qu'**il est constitué de polyamide renforcé de fibres de verre.

15. Elément de retenue selon l'une quelconque des revendications 1 à 14 pour le montage d'un ou de plusieurs semi-conducteur(s) sur un support de circuits.
